(19) Europäisches Patentamt
European Patent Office
Office européen des brevets

(11) Publication number : 0 229 629 B1

# (12) EUROPEAN PATENT SPECIFICATION

(45) Date of publication of patent specification : 20.03.91 Bulletin 91/12

(51) Int. Cl.$^5$ : G03F 7/075

(21) Application number : 87100100.4

(22) Date of filing : 07.01.87

## (54) Photosensitive resin composition.

(30) Priority : 08.01.86 JP 501/86

(43) Date of publication of application : 22.07.87 Bulletin 87/30

(45) Publication of the grant of the patent : 20.03.91 Bulletin 91/12

(84) Designated Contracting States : DE FR GB

(56) References cited :
EP-A- 0 147 127
DE-A- 2 363 620
PATENT ABSTRACTS OF JAPAN, vol. 7, no. 130 (P-202)[1275], 7th June 1983; & JP-A-58 48 045 (SHINETSU KAGAKU KOGYO K.K.) 19-03-1983
PATENT ABSTRACTS OF JAPAN, vol. 9, no. 217 (P-385)[1940], 4th September 1985; & JP-A-60 76 739 (NIPPON DENSHIN DENWA KOSHA) 01-05-1985
PATENT ABSTRACTS OF JAPAN, vol. 4, no. 58 (P-9)[540], 30th April 1980; & JP-A-55 26 576 (TORAY K.K.) 26-02-1980

(56) References cited :
CHEMICAL ABSTRACTS, vol. 91, no. 22, November 1979, page 643, abstract no. 184893b, Columnbus, Ohio, US; K. KOSEKI et al.: "Studies on photosensitive polydiorganosiloxane. Part I", & NIPPON INSATSU GAKKAI RONBUNSHU 1976, 16(3), 126-30

(73) Proprietor : HITACHI, LTD.
6, Kanda Surugadai 4-chome
Chiyoda-ku, Tokyo 101 (JP)

(72) Inventor : Sugiyama, Hisashi
Hachimanyama Apt. 125 1545, Yoshida-cho
Totsuka-ku Yohohama-shi Kanagawa-ken (JP)
Inventor : Nate, Kazuo
1670-115, Naruse
Machida-shi Tokyo (JP)
Inventor : Inoue, Takashi
Hachimanyama Apt. 241 1545, Yoshida-cho
Totsuka-ku Yokohama-shi Kanagawa-ken (JP)
Inventor : Mizushima, Akiko
1-2-19-1932, Noshichiri Totsuka-ku
Yokohama-shi Kanagawa-ken (JP)

(74) Representative : Dost, Wolfgang, Dr.rer.nat., Dipl.-Chem. et al
Patent- und Rechtsanwälte
Bardehle-Pagenberg-Dost-Altenburg & Partner Postfach 86 06 20
W-8000 München 86 (DE)



Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a photosensitive resin composition, and more particularly, it relates to a photosensitive resin composition suitable for use as the top layer resist used in the two-layer resist process which requires a good resistance to oxygen plasma. The composition of the present invention will be used to form fine patterns necessary for the production of semiconductor elements.

The production of electronics components such as semiconductor elements, magnetic bubble memory, and integrated circuits involves the process of pattern formation. Heretofore, the pattern formation has been generally accomplished by using a photoresist which is sensitive to ultraviolet light or visible light. There are two types of photoresists : A negative type characterized by that the exposed part becomes insoluble in the developing solution ; and a positive type characterized by that the exposed part becomes soluble in the developing solution. The negative type is superior to the positive type in sensitivity, adhesion to the substrate necessary for wet etching, and chemical resistance. For this reason, the photoresist of negative type has been predominant. However, with the advent of semiconductor elements having a high degree of integration and a pattern composed of extremely fine lines arranged close to each other, and also with the acceptance of dry etching for the patterns, there has arisen a demand for a photoresist having a high resolution and high resistance to dry etching. Nowadays, therefore, the photoresist of positive type has become to account for a large share. The most widely used photoresist of positive type is that of alkali development type which is based on an alkali-soluble novolak resin. It is outstanding in sensitivity, resolution, and dry etching resistance among many photoresists of positive type. It is explained in Kodak microelectronics Seminor Proceedings, p. 116, (1976), by J.C. Strieter.

From Patent Abstracts of Japan, Vol. 7, No. 130 (P-202) [1275] a photosensitive composition is known comprising an organosilicon polymer and a quinonediazide. The organosilicon polymer is said to be freed of phenolic or alcoholic hydroxyl groups.

Patents Abstracts of Japan, Vol. 9, No. 217 (P-385) [1940] describes a photosensitive resin composition comprising a siloxane polymer with a bisazido compound and a sensitizer.

Finally, DE-A 2 363 620 discloses a dry, presensitized planographic plate comprising one or more layers of a silicon rubber, a photosensitive azide compound, a cyclic rubber and a vinylidene chloride-acrylonitrile copolymer.

The photoresist of positive type, however, does not meet the recent requirements for higher density and higher integration and multilayer wiring structure of semiconductor elements, so long as the conventional monolayer resist method is employed. In such semiconductor elements, there are irregularities on the substrate surface on which the pattern is to be made. Forming an accurate pattern of submicron level on such a substrate surface is very difficult on account of the variation of development condition resulting from the difference of resist film thickness, and the irregular reflection and standing wave of the exposing light that occur at the stepped part on the surface. In order to overcome the difficulty encountered in forming a submicron pattern on the stepped substrate, there has been proposed the multi-layer resist method. This method includes the three-layer resist method and the two-layer resist method. In the case of three-layer resist method, the stepped substrate is coated with an organic flattening film, and then an inorganic intermediate layer and resist are placed on top of the other. A desired pattern is formed on the resist. Using the resist as a mask, the intermediate layer is subjected to dry etching. And finally, using the inorganic intermediate layer as a mask, a pattern is formed on the organic flattening film by $O_2$RIE. This method has long been studied because basically it can be carried out using the existing technology. However, it has a shortcoming of being very complex in process. Another disadvantage of this method is that cracks and pinholes are liable to occur in the intermediate layer because the organic film, inorganic film, and organic film of different properties are placed on top of the other. In contrast to the three-layer resist method, the two-layer resist method does not suffer cracks and pinholes because it employs a resist having the properties of both the resist and inorganic intermediate layer used in the three-layer resist method. In other words, this resist is resistant to oxygen plasma. The two-layer method is simpler in process than the three-layer method. Unfortunately, the conventional resist (top layer resist) used in the three-layer resist cannot be used in the two-layer resist method. Thus it is necessary to develop a new resist having resistance to oxygen plasma.

For reasons mentioned above, there has been a demand for a positive type photoresist having good resistance to oxygen plasma, high sensitivity, and high resolution which can be used for the top layer resist in the two-layer resist method and also can be developed with an alkali without the change of the existin process.

It is an object of the present invention to provide a positive type photosensitive resin composition for alkali development which has high sensitivity, high resolution, and resistance to oxygen plasma.

The object is achieved with a photosensitive resin composition defined in claim 1.

In the case of three-layer photoresist method, an intermediate metal oxide film is used as the oxygen

plasma resistant film. Therefore, in the case of two-layer resist method, it is adequate to use an organometallic polymer for the resist ; however, it is difficult to impart the photosensitivity to the organometallic polymer itself.

After extensive studies, it was found that if the alkali-soluble organosilicon polymer defined in claim 1 is incorporated with a o-quinonediazide as photosensitive dissolution inhibitor, the exposed part alone becomes selectively soluble in an alkali developing solution, whereby there is obtained a positive type resist pattern.

A description will be made of the alkali-soluble organosilicon polymer which is one of the major constituents of the photosensitive resin composition of the invention. The silicon in the alkali-soluble organosilicon polymer is required to be efficiently converted into a silicon oxide film. Therefore, the silicon in the alkali-soluble organosilicon polymer is present in the main chain rather than in the side chain. For the organosilicon polymer to be alkali-soluble, it has on its side chain an organic group with a phenolic hydroxyl group. For sufficient alkali-solubility, the ratio of the organic group to the side chain should preferably be high.

The alkali-soluble organosilicon polymer includes alkali-soluble silmethylene polymers, alkali-soluble siloxane polymers and alkali-soluble polyorganosilsesquioxane polymers.

An example of the alkali-soluble silmethylene polymers is a polymer which contains more than 40% of the unit represented by the following formula (1) in the polymer skeleton.

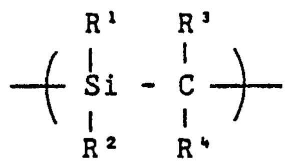

(1)

wherein $R^1$, $R^2$, $R^3$, and $R^4$ are monovalent organic groups. At least one of the four side chains is an organic group having a phenolic hydroxyl group, and the organic group having a phenolic hydroxyl group should preferably be on a carbon atom. The monovalent organic group includes hydrogen, alkyl groups, vinyl groups, and aromatic groups, and derivatives thereof. $C_1$-$C_6$ alkyl groups are preferable for $R^1$ and $R^2$, and hydrogen is preferable for $R^3$. The organic group having a phenolic hydroxyl group includes, for example, phenols, catechols, isomers thereof, and $C_1$-$C_6$ alkyl groups having them. Phenols and catechols are preferable.

An example of the alkali-soluble siloxane polymers is a polymer which contains more than 40% of the unit represented by the following formula (2) in the polymer skeleton.

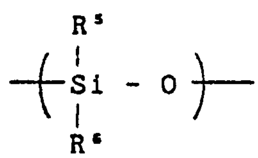

(2)

wherein $R^5$ and $R^6$ are monovalent organic groups. At least either of $R^5$ and $R^6$ is an organic group having a phenolic hydroxyl group. The monovalent organic group includes hydrogen, alkyl groups, vinyl groups, and aromatic groups, and derivatives thereof. $C_1$-$C_6$ alkyl groups are preferable. The organic group having a phenolic hydroxyl group includes phenols, catechols, and $C_1$-$C_6$ alkyl groups having their isomers. $C_1$-$C_2$ alkyl groups having phenols or catechols are preferable.

An example of the alkali-soluble polyorganosilsesquioxane polymers is a polymer which contains more than 40% of the unit represented by the following formula (3) in the polymer skeleton.

$$(R^7\text{-}SiO_{3/2}) \quad (3)$$

wherein $R^7$ is a monovalent organic group having phenolic hydroxyl groups, such as $C_1$-$C_6$ alkyl groups having phenols or catechols or derivatives thereof. $C_1$-$C_2$ alkyl groups having phenols or catechols are preferable.

These alkali-soluble organosilicon polymers are soluble in alkaline solutions such as an aqueous solution of tetramethylammonium hydroxide and an aqueous solution of sodium hydroxide. They are also readily soluble in general-purpose solvents such as alcohols, ethers, amides, ketones, esters, and cellosolve. These alkali-soluble organosilicon polymers are not corroded by oxygen plasma and are extremely resistant to dry etching.

A description will be of the o-quinonediazide present as photosensitive dissolution inhibitor which is another major constituent of the composition of the invention. The photosensitive dissolution inhibitor in the photosensitive resin composition of alkali development type has the following functions. In the unexposed part, it acts as an alkali-dissolution inhibitor for the alkali-soluble organosilicon polymer ; and in the exposed part, it undergoes photolysis to give an alkali-soluble compound or lose the alkali-dissolution inhibiting effect, whereby rendering the exposed part alkali-soluble. The following compounds (I) to (XXIV) are examples for preferred o-quinone diaxides.

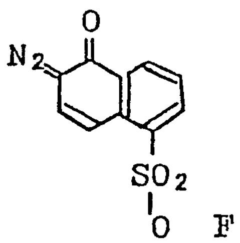

(I)

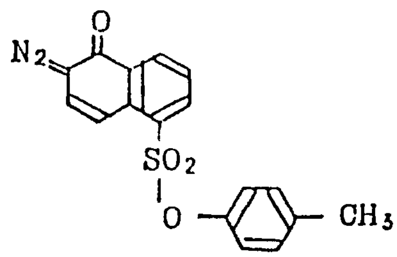

(II)

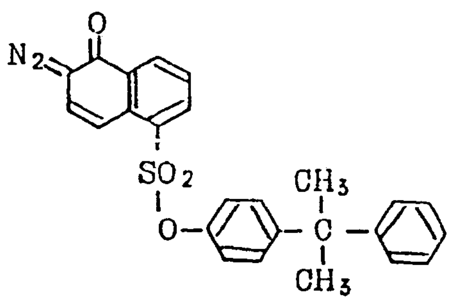

(III)

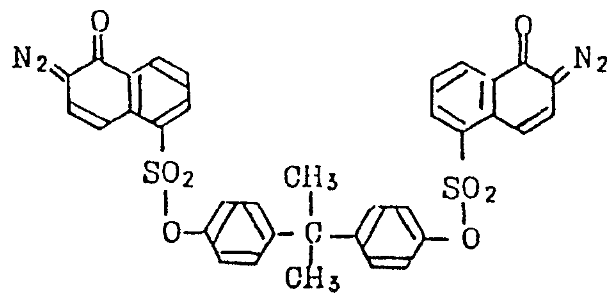

(IV)

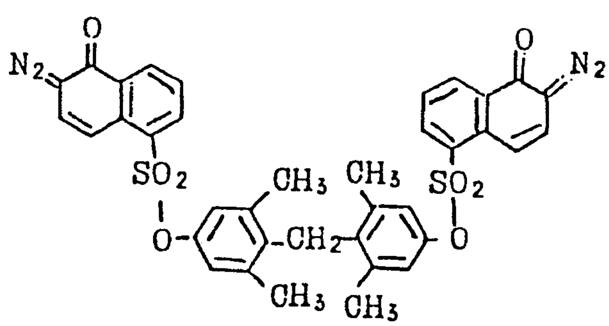

(V)

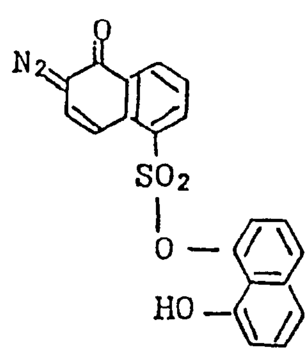

(VI)

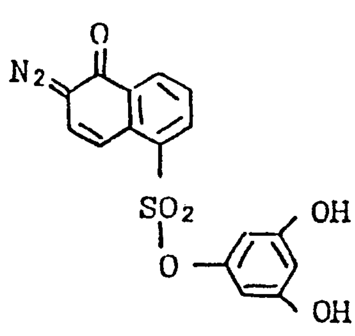

(VII)

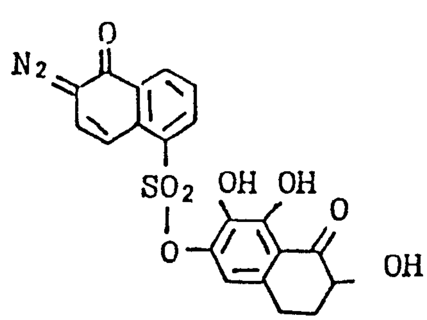

(VIII)

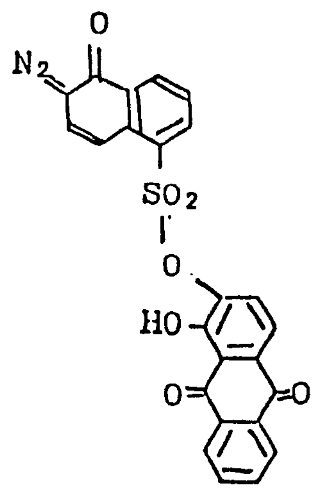

(IX)

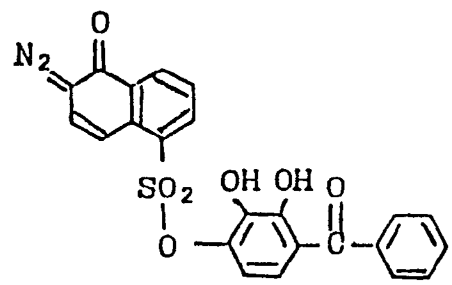

(X)

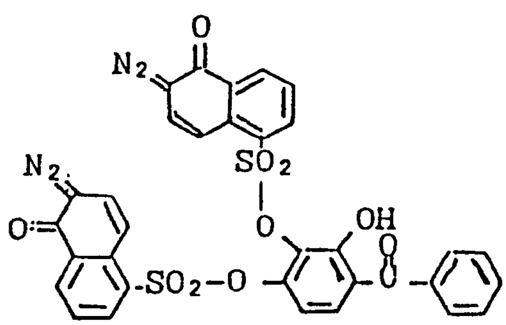

(XI)

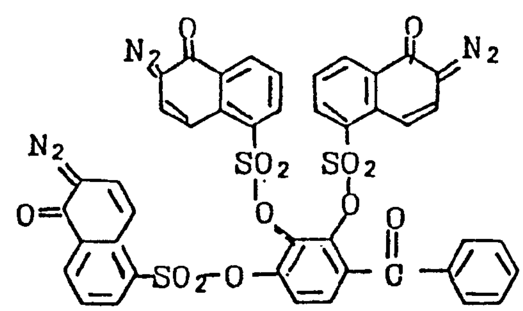

(XII)

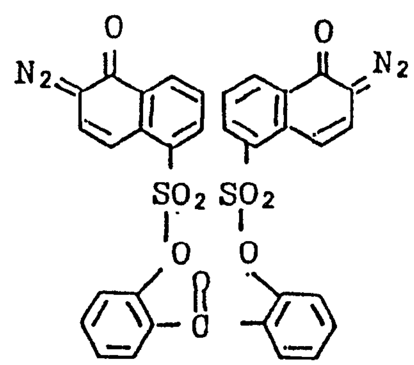

(XIII)

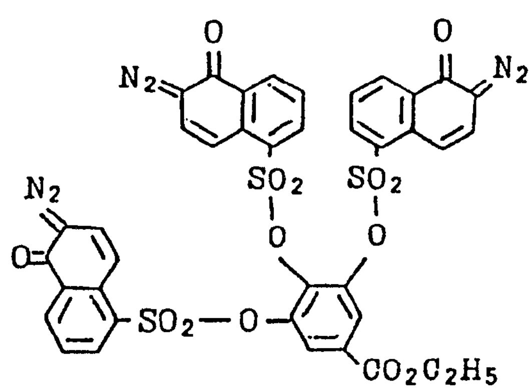

(XIV)

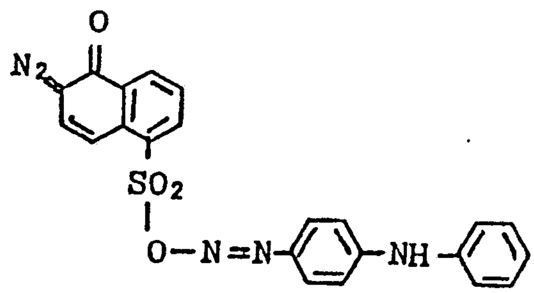

(XV)

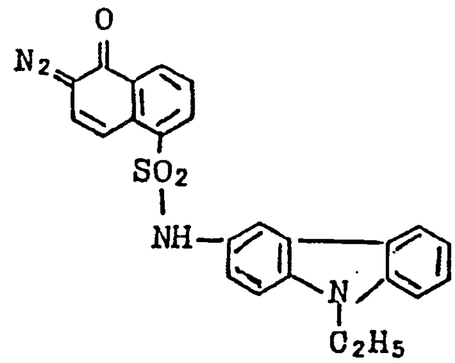

(XVI)

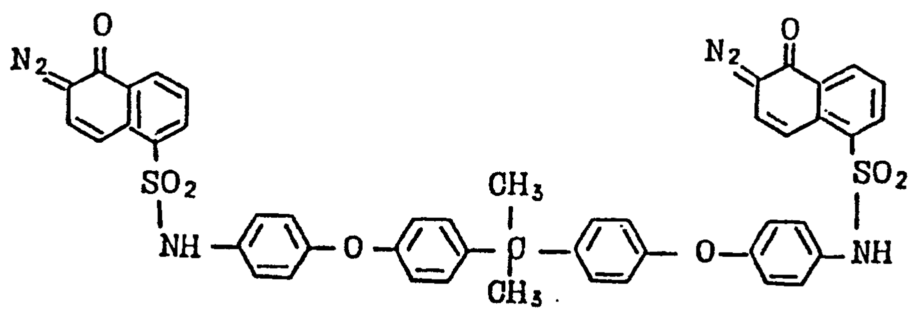

(XVII)

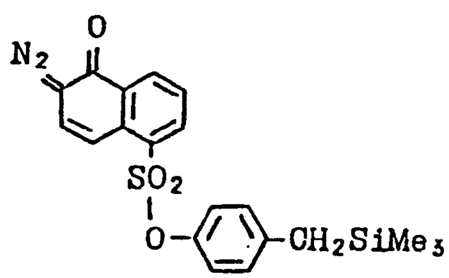

(XVIII)

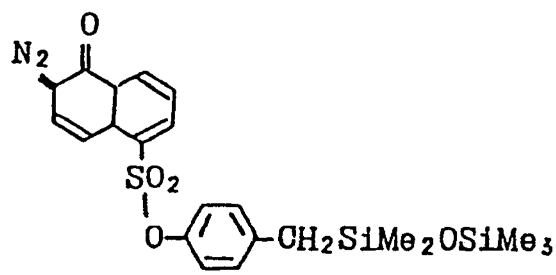

(XIX)

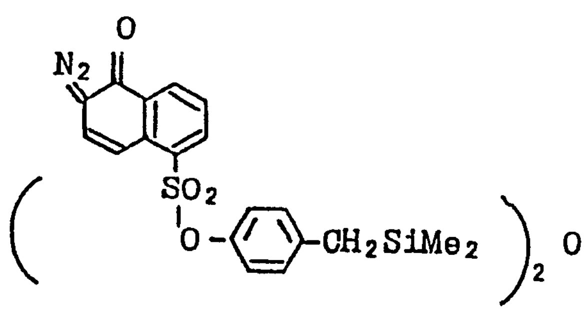

(XX)

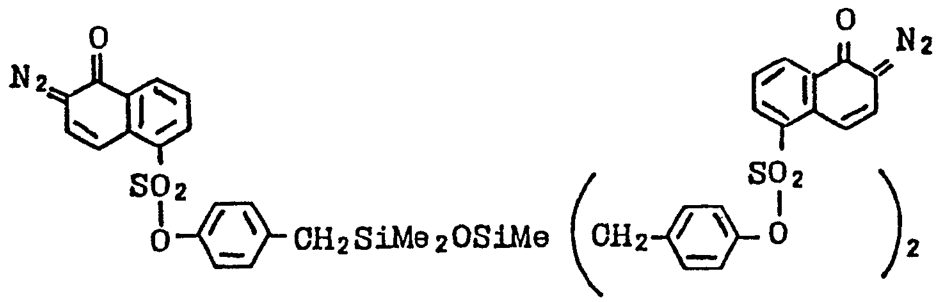

(XXI)

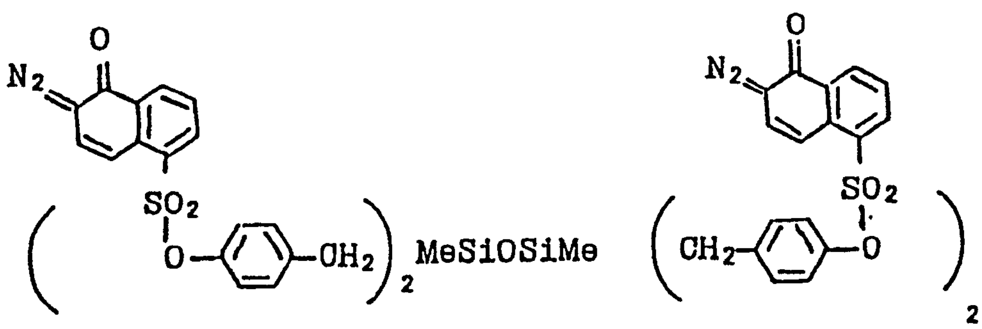

(XXII)

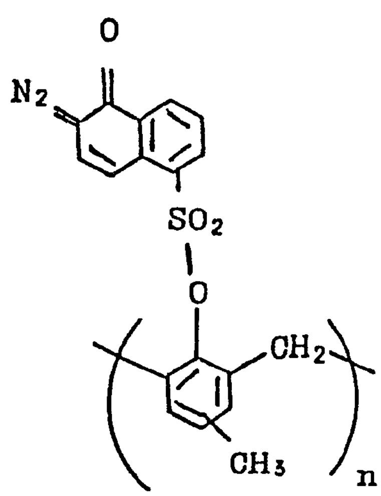

(XXIII)

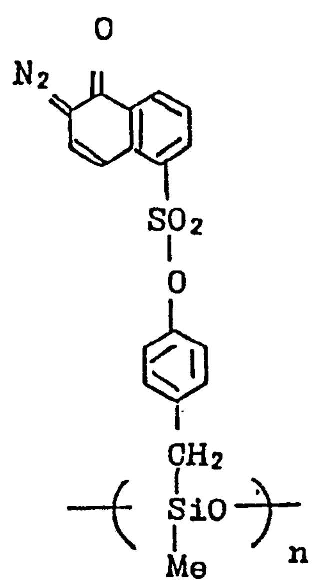

(XXIV)

A description will be made of the usage of the composition of the invention for forming a pattern on a semiconductor element.

First, a photosensitive resin composition is prepared from 70 to 95 wt% of polymer and 30 to 5 wt% of photosensitive dissolution inhibitor. (The polymer may contain 60 to 100 wt% of alkali-soluble organosilicon polymer

and 40 to 0 wt% of film former such as novolak resin. The amount of film former should not exceed 40 wt% from the standpoint of oxygen plasma resistance. The alkali-soluble organosilicon polymer may be used alone or in the form of mixture. The photosensitive dissolution inhibitor may be used alone or in the form of mixture. An excess amount of photosensitive dissolution inhibitor is not preferable from the standpoint of sensitivity and oxygen plasma resistance.) The thus prepared photosensitive resin composition is dissolved in an ordinary organic solvent such as ethyl cellosolve acetate. The solution is applied by spin coating to the lower-layer resist in the two-layer resist method, followed by prebaking at a proper temperature. Thus there is obtained a film of the photosensitive resin composition of the invention. The film is irradiated with light according to a desired pattern. The irradiated part is selectively dissolved by using an alkali developing solution such as an aqueous solution of tetramethylammonium hydroxide, to give a positive resist pattern. When the lower layer resist is processed, the above-mentioned resist pattern is used as a mask and the lower layer resist is subjected to dry etching with oxygen plasma. In this way, it is possible to form a pattern having a high aspect ratio.

The photosensitive resin composition of the invention will find use not only as the top-layer resist for the two-layer resist method but also as the resist for microfabrication of organic insulations.

The photosensitive resin composition of the invention produces the following effects. The alkali-soluble organosilicon polymer, which is one major constituent, forms a silicon oxide film upon exposure to oxygen plasma, and use as the film acts as an oxygen plasma resistant film. The o-quinonediazide photosensitive dissolution inhibitor, which is another major constituent, prevents the alkali-soluble organosilicon polymer at the unexposed part from dissolving in an alkali and permits the alkali-soluble organosilicon polymer at the exposed part to dissolve in an alkali developing solution. Thus the combination of the two major constituents provides a positive type photoresist having a high sensitivity, high resolution, and high resistance to oxygen plasma.

The examples of the invention will be explained in the following. They should not be construed to limit the scope of the invention. The first description is concerned with the synthesis of the alkali-soluble organosilicon polymer as the major constituent of the composition of the invention.

Synthesis Example 1

Synthesis of poly(1,1-dimethyl-2-p-hydroxyphenylsilmethylene) and poly(1,1-dimethyl-2-p-methoxyphenylsilmethylene-co-1,1-dimethyl-2-p-hydroxyphenylsilmethylene)

1.1 Synthesis of chlorodimethyl-p-methoxybenzylsilane

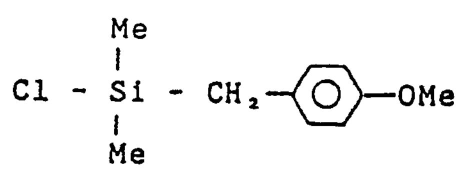

In a 2-liter three-neck flask equipped with a stirrer, reflux condenser, dropping funnel, and thermometer were placed 31.0 g (1.28 mol) of magnesium powder, 129 g (1 mol) of dimethyldichlorosilane, and 500 ml of diethyl ether. With the flask cooled below 10°C, a mixture of 100 g (0.639 mol) of p-methoxybenzyl chloride and 250 ml of diethyl ether was added dropwise over 4 hours from the dropping funnel. After aging at room temperature for 1 hour, excess magnesium and magnesium chloride were removed by filtration under reduced pressure. The filtrate was distilled to give 87.8 g (0.409 mol) of the desired product.
Yield : 64.0%, boiling point : 80°C/1 mmHg.
NMR spectrum (60 MHz, $CCl_4$, $CH_2Cl_2$ δ5.33) : δ0.46 (6H, s), 2.40 (2H, s), 3.83 (3H, s), 6.82 (2H, d, J = 9.0 Hz), 7.08 (2H, d, J = 9.0 Hz).
IR spectrum (ν $cm^{-1}$) : 2970, 1620, 1520, 1475, 1310, 1260, 1195, 1090, 1055, 855, 825, 780.

1.2 Synthesis of bromo-p-methoxyphenylchlorodimethylsilylmethane (dl) :

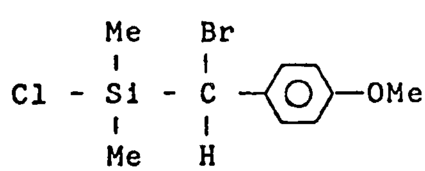

In a 500-ml three-neck flask equipped with a stirrer and reflux condenser were placed 43.2 g (0.200 mol)

of chlorodimethyl-p-methoxybenzylsilane and 200 ml of carbon tetrachloride. With stirring, 35.6 g (0.200 mol) of N-bromosuccinimide was added slowly. After aging for 1 hour, succinimide was removed by filtration under reduced pressure. The filtrate was distilled to give 31.7 g (0.108 mol) of the desired product. Yield : 54.0%, boiling point : 113-117°C/2.5 mmHg, melting point : lower than 30°C. NMR spectrum (60 MHz, $CCl_4$, TMS) : δ0.50 (3H, s), 0.60 (3H, s), 3.73 (3H, s), 4.32 (1H, s), 6.73 (2H, d, J = 9 Hz), 7.19 (2H, d, J = 9 Hz).
IR spectrum (ν $cm^{-1}$) : 1610, 1510, 1466, 1305, 1260, 1185, 1040, 865, 845, 820, 800.

1.3 Synthesis of poly(1,1-dimethyl-2-p-methoxyphenylsilmethylene)

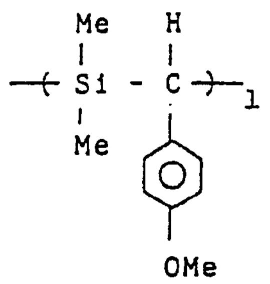

l corresponds to (m+n), i.e., the homopolymer polymerisation degree is equal to the copolymer polymerisation degree, see below.

In a 500-ml three-neck flask equipped with a Herschberg stirrer, reflux condenser, and dropping funnel, with the atmosphere therein replaced with nitrogen, were placed 7.6 g (0.33 g atom) and 120 ml of toluene. Upon heating and stirring, there were obtained fine sodium particles. With stirring and refluxing, a mixture of 44.1 g (0.15 mol) of bromo-p-methoxyphenylchlorodimethylsilylmethane and 30 ml of toluene was added dropwise over 1 hour. After aging for 1 hour, the reaction mixture was poured into methanol to remove excess sodium and to cause the polymer to separate. After filtration, the polymer dissolved in tetrahydrofuran was poured into water to remove the sodium salt. The filtered polymer was washed with methanol, followed by drying under reduced pressure. Thus there was obtained 10 g of the desired product. Yield : 37%, softening point : 121-125°C, average molecular weight : 3,400.
NMR spectrum (60 MHz, $C_6D_6$, $CH_2Cl_2$, δ5.33) : δ1.27 (6H, br.s), 4.43 (3H, br.s), 7.4-8.7 (4H, br.s).
IR spectrum (ν $cm^{-1}$) : 2960, 2850, 1610, 1510, 1470, 1385, 1300, 1260, 1100, 1045, 860, 790.

1.4 Synthesis of poly(1,1-dimethyl-2-p-hydroxyphenylsilmethylene) and
poly(1,1-dimethyl-2-p-methoxyphenylsilmethylene-co-1,1-dimethyl-2-p-hydroxyphenylsilmethylene)

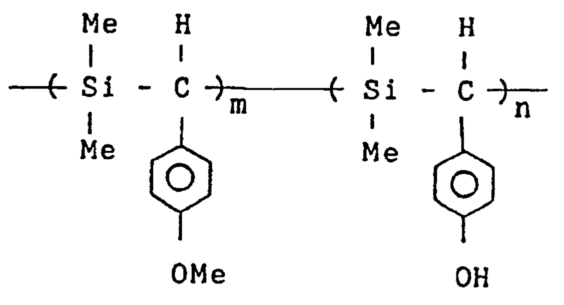

(XXV)

In a 25-ml eggplant-shape flask equipped with a reflux condenser were placed 0.50 g (2.8 mmol in terms of monomer units) of poly(1,1-dimethyl-2-p-methoxyphenylsilmethylene) having a weight-average molecular weight of 3,000, 1.5 ml of chloroform, and 0.88 g (4.4 mmol) of trimethylsilyl iodide. The reactants were stirred with a magnetic bar to carry out reaction for 4 hours. 4 ml of methanol was added, and stirring was continued for 3 hours. Low-boiling products were distilled away at room temperature under reduced pressure. The residues were extracted with ether. The ether solution was washed with an aqueous solution of sodium hydrogen sulfite, an aqueous solution of sodium hydrogen carbonate, and an aqueous solution of sodium chloride. The ether was distilled away under reduced pressure. The resulting polymer was reprecipitated from a mixture of tetrahydrofuran and water. Upon drying with heating under reduced pressure, there was obtained 0.23 g of desired product. Weight-average molecular weight : 1,800, OH content : 100%, and softening point : 107-113°C. NMR spectrum (60 MHz, DMSO-ds, δ5.68) : δ0.79-0.51 (6H, br.s), 6.15-7.35 (4H, br.s), hydroxy proton not

detectable.
IR spectrum (ν $cm^{-1}$) : 3380, 2980, 1510, 1270, 1100, 1040, 860, 810.

The OH content can be controlled by changing the amount of trimethylsilyl iodide or the reaction time. If 1.3 equivalent of trimethylsilyl iodide for methoxy group is reacted for 4 hours, 90% of the methoxy groups is converted into hydroxyl groups. The conversion rate was 70% at 0.80 equivalent, 55% at 0.65 equivalent, and 40% at 0.50 equivalent.

Synthesis Example 2

Synthesis of poly(methyl-p-hydroxybenzylsiloxane) and poly(methyl-p-methoxybenzylsiloxane-co-methyl-p-hydroxybenzylsiloxane)

2.1 Synthesis of methyldichloro-p-methoxybenzylsilane

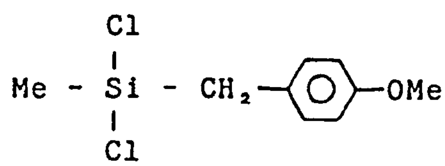

In a 1-liter three-neck flask equipped with a stirrer, reflux condenser, dropping funnel, and thermometer were placed 23.3 g (1.00 mol) of magnesium powder, 82.6 g (0.640 mol) of methyltrichlorosilane, and 200 ml of diethyl ether. Magnesium was activated with iodine and dibromoethane. The flask was cooled to 10°C to 0°C. A mixture of 50.0 g (0.319 mol) of p-methoxybenzyl chloride and 300 ml of diethyl ether was added dropwise over 4 hours from the dropping funnel. After aging at room temperature for 1 hour, excess magnesium and magnesium chloride were removed by filtration under reduced pressure. The filtrate was distilled to give 48.8 g (0.208 mol) of the desired product. Yield : 65%
The physical properties of the desired product were as follow :
Boiling point : 80-88°C/2 mmHg.
NMR spectrum (60 MHz, $CCl_4$, $CH_2Cl_2$ δ5.33) : δ0.79 (3H, s), δ2.68 (2H, s), δ3.84 (3H, s), δ6.80 (2H, d, J = 9 Hz), δ7.18 (2H, d, J = 9 Hz).
IR spectrum (ν $cm^{-1}$) : 1620, 1520, 1480, 1310, 1260, 1190, 1100, 1050, 850, 810, 755.

2.2 Synthesis of methyl-p-methoxybenzylsiloxane trimer

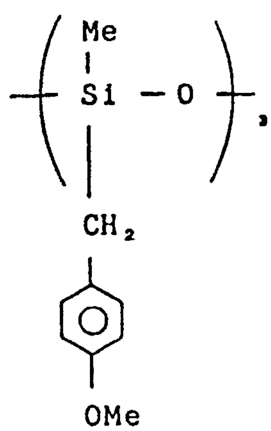

In a 1-liter three-neck flask equipped with a stirrer, reflux condenser, and dropping funnel was placed 200 ml of water. With stirring, a mixture of 85.6 g (0.364 mol) of methyldichloro-p-methoxybenzylsilane and 200 ml of ethyl ether was added dropwise over 4 hour at room temperature. After aging for 1 hour, the organic materials were extracted with diethyl ether. The extract was washed with water until the washings were neutral. The diethyl ether solution was dried with sodium sulfate. Diethyl ether was distilled away, and distillation was continued together with calcium hydride. Thus there was obtained 20.3 g (37.5 mmol) of the desired product. Yield: 31%
The physical properties of the desired product were as follow :

Boiling point : 241°C/0.8 mmHg to 253°C/0.13 mmHg.
NMR spectrum (60 MHz, $CCl_4$, $CH_2Cl_2$ δ5.33) : δ-0.02, δ0.03, δ0.16 (9H, s × 3), δ1.96, δ2.07 (6H, s × 2), δ3.79 (9H, s), δ6.74 (CH, d, J = 9 Hz), δ6.98 (6H, d, J = 9 Hz).

IR spectrum (ν $cm^{-1}$) : 1620, 1520, 1470, 1305, 1260, 1220, 1185, 1090, 1030, 840, 815, 770.

2.3 Synthesis of poly(methyl-p-methoxybenzylsiloxane)

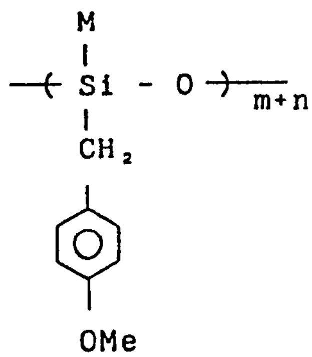

In a 100-ml eggplant-shape flask containing a magnet rod were placed 9.0 g (17 mmol) of methyl-p-methoxybenzylsiloxane trimer and 45 mg (0.5 wt%) of tetramethylammonium hydroxide. With the mouth stoppered, the flask was dipped in an oil bath at 80°C, and the reactants were stirred by the magnet rod. Four minutes after the start of reaction, the weight-average molecular weight reached 5,000. It reached 10,000 after 10 minutes, 14,000 after 20 minutes, 16,000 after 30 minutes, and 19,000 after 60 minutes. After reaction for an adequate period of time, the flask was removed from the oil bath and cooled with water, to give a product having a desired weight-average molecular weight. The content in the flask was used as such for the subsequent reaction. The physical properties of the desired product were as follow :
NMR spectrum (60 MHz, $CCl_4$, $CH_2Cl_2$ δ5.33) : δ0.00 (3H, br.s), δ1.94 (2H, br.s), δ3.71, δ3.80 (3H, s × 2), δ6.82 (4H, br.s).
IR spectrum (ν $cm^{-1}$) : 2975, 2850, 1620, 1520, 1475, 1305, 1260, 1225, 1190, 1090, 1040, 845, 810, 775, 755

2.4 Synthesis of poly (methyl-p-hydroxybenzylsiloxane) and poly (methyl-p-methoxybenzylsiloxane-co-methyl-p-hdyroxy-benzylsiloxane)

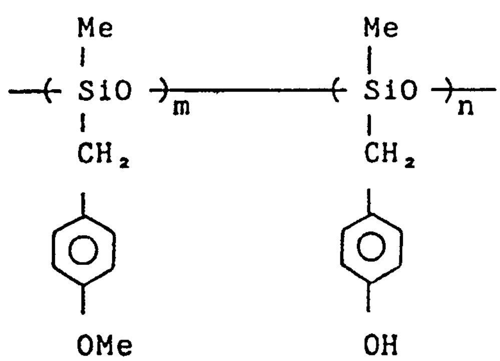

(XXVI)

In a flask equipped with a reflux condenser was placed poly(methyl-p-methoxybenzylsiloxane), and the atmosphere in the flask was replaced with nitrogen. 30 ml of chloroform was added to the flask to make a uniform solution of the polymer. A predetermined amount of trimethylsilyl iodide was added. The reactants were stirred at room temperature for 3 hours. 20 ml of methanol was added, and stirring was continued for 2 hours. After the reaction was completed, the low-boiling fractions were distilled away under reduced pressure at room temperature. The residues were extracted with tetrahydrofuran and diethyl ether. The extract was washed with an aqueous solution of sodium hydrogen sulfite, an aqueous solution of sodium hydrogen carbonate, and an aqueous solution of sodium chloride. The solvent was distilled away under reduced pressure. Thus there was obtained the desired product. The methoxy groups were 100% converted into hydroxyl groups by reacting 1.5

equivalent of trimethylsilyl iodide for the methoxy groups. The conversion rate was 90% at 1.3 equivalent, 71% at 0.76 equivalent, 58% at 0.65 equivalent, and 41% at 0.47 equivalent.

The physical properties of the desired product were as follow :

Melting point : 53-68°C (weight-average molecular weight : 10,000, 80% OH polymer)

NMR spectrum (60 MHz, $CD_3CSCD_3$, $CH_2Cl_2$ δ5.68) : δ-0.07 (br.s, $CH_3$), δ1.85 (br.s, $-CH_2-$), δ4.00 (br.s, $-OCH_3$), 66.61 (br.s, aromatic protons), δ8.81 (br.s, –OH)

IR spectrum (ν $cm^{-1}$) : 3320, 1620, 1510, 1450, 1270, 1240, 1180, 1070, 840, 800

Synthesis Example 3 Synthesis of poly(p-hydroxybenzylsilsesquioxane) and poly(p-methoxybenzylsilsesquioxane-co-p-hydroxybenzylsilsesquioxane)

3.1 Synthesis of p-methoxybenzyltrichlorosilane

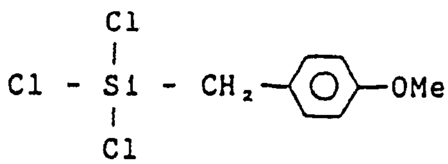

In a 2-liter three-neck flask equipped with a stirrer, reflux condenser, dropping funnel, and thermometer were placed 30 g (1.2 g atom) of magnesium powder, 170 g (1.00 mol) of silicon tetrachloride, and 500 ml of diethyl ether. With the flask cooled below 10°C, a mixture of 100 g (0.639 mol) of p-methoxybenzyl chloride and 200 ml of diethyl ether was added dropwise over 4 hours from the dropping funnel. After aging at room temperature for 1 hour, excess magnesium and magnesium chloride were removed by filtration under reduced pressure. The filtrate was distilled to give 44.0 g (0.172 mol) of the desired product. Yield : 26.9% boiling point: 117.5-119.5°C/3.0 mmHg

NMR spectrum (60 MHz, $CCl_4$, $CH_2Cl_2$ δ5.33) : δ2.91 (2H, s), 3.90 (3H, s), 6.91 (2H, d, J = 8 Hz), 7.20 (2H, d, J = 8 Hz).

3.2 Synthesis of poly(p-methoxybenzylsilsesquioxane)

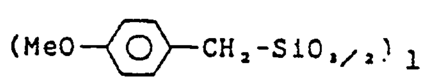

1 means (m + n), see hereinbefore

In a 100-ml three-neck flask equipped with a magnet rod, reflux condenser, and dropping funnel were placed 11 g (0.13 mmol) of sodium hydrogen carbonate and 40 ml of water. A mixture of 10.23 g (40.0 mmol) of p-methoxybenzyltrichlorosilane and 10 ml of diethyl ether was added dropwise over 30 minutes from the dropping funnel, followed by aging for 30 minutes. After the reaction was completed, the reaction mixture was extracted with ether, and the extract was dried with sodium sulfate. Diethyl ether was distilled away under reduced pressure. Thus there was obtained 5.10 g of hydrolyzate.

NMR spectrum (60 MHz, $CDCl_3$, $CH_2Cl_2$ δ5.33) : δ2.03 (2H, br.s), 3.80 (3H, br.s), 6.80 (4H, br.s)

IR spectrum (ν $cm^{-1}$) : 3400, 2950, 2850, 1610, 1510, 1460, 1300, 1250, 1180, 1090, 1035, 890, 835, 790, 760

Weight-average molecular weight : 2,000

In a 25-ml flask were placed 4.80 g of the above-mentioned hydrolyzate and 49 mg of 10 wt% methanol solution of potassium hydroxide. The reactants were heated at 200°C for 2 hours. After the reaction was completed, the reaction mixture was dissolved in benzene, and the solution was added dropwise to methanol to cause solids to separate. After filtration and drying under reduced pressure, there was obtained 4.00 g of the desired product.

NMR spectrum (60 MHz, $CDCl_3$, $CH_2Cl_2$ δ5.33) : δ1.91 (2H, br.s), 3.78 (3H, br.s), 6.73 (4H, br.s)

IR spectrum (ν $cm^{-1}$) : 2950, 2850, 1615, 1515, 1465, 1305, 1250, 1195, 1120, 1040, 840, 800, 770

Weight-average molecular weight : 3,300

3.3 Synthesis of poly (p-hydroxybenzylsilsesquioxane) and poly (p-methoxybenzylsilsesquioxane-co-p-hdyroxybenzylsilsesquioxane)

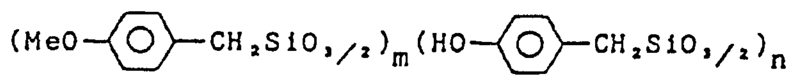
XXVII

In a 100-ml eggplant-shape flask equipped with a reflux condenser were placed 3.73 g (21.6 mmol in terms of $MeOC_6H_4CH_2SiO_{3/2}$ unit) of poly(p-methoxybenzylsilsesquioxane), 20 ml of chloroform, and 6.92 g (34.6 mmol) of trimethylsilyl iodide. The reactants were stirred by the magnet rod at 70°C for 72 hours. 20 ml of methanol was added at room temperature and stirring was continued for 30 minutes. Low-boiling fractions were distilled away under reduced pressure and the residues were extracted with a mixed solvent of diethyl ether and tetrahydrofuran. The extract was washed with an aqueous solution of sodium hydrogen sulfite, an aqueous solution of sodium hydrogen carbonate, and an aqueous solution of sodium chloride. The solvent was distilled away under reduced pressure. The thus obtained polymer was reprecipitated from acetone/hexane, followed by drying with heating under reduced pressure. Thus there was obtained 2.71 g of the desired product. Weight-average molecular weight : 4,000

Content of hydroxyl group : 100%

NMR spectrum (60 MHz, DMSO-d6, $CH_2Cl_2$ δ5.68) : δ1.75 (2H, br.s), 6.58 (4H, br.s), 8.88 (–OH, br.s)

IR spectrum (ν $cm^{-1}$) : 3350, 1620, 1515, 1450, 1240, 1185, 1120, 1040, 840, 805, 760

The content of hydroxyl groups can be controlled by changing the amount of trimethylsilyl iodide or the reaction time. In the case where 1.6 equivalent of trimethylsilyl iodide was used, the content was 39% with the reaction time of 4 hours, 54% with 7 hours, 75% with 12 hours, 85% with 22 hours, and 95% with 48 hours.

The content of hydroxyl groups in the polymer was determined by tracing the conversion of the methoxy group into the trimethylsiloxy group that takes place when the reaction is carried out in deutrochloroform. NMR spectrometry was employed to trace the conversion.

The above-mentioned polymers were examined for solubility in typical solvents. Those polymers containing more than 40% of hydroxyl groups are soluble in methanol, tetrahydrofuran, N,N-dimethylacetamide, 2-methylcyclohexanone, isoamyl acetate, methyl cellosolve, and dimethyl sulfoxide, but are insoluble in toluene, hexane, and carbon tetrachloride. They are soluble in aqueous solutions of tetramethyl ammonium hydroxide and sodium hydroxide.

The resistance to oxygen plasma was evaluated in the following manner. A 10 wt% solution of the polymer sample in ethyl cellosolve was applied to a silicon substrate by spin coating method. A 0.2 μm thick polymer film was formed by prebaking at 100°C for 30 minutes. The film was exposed to oxygen plasma (oxygen pressure : 0.5 Torr, RF 300 W) for 20 minutes using a barrel type etcher. The polymer film was not corroded at all. However, the film of the polymer XXV was corroded at a rate of 86 Å/min, the film of the polymer XXVI was corroded at a rate of 290 Å/min, and the film of the polymer XXVII was corroded at a rate of 23 Å/min when they were exposed to oxygen plasma using a parallel flat plate type $O_2$RIE apparatus (oxygen pressure : 20 mtorr, RF 200W (14 MHz), cathode bias voltage – 130 V). Commercial products which are said to have comparatively good resistance to oxygen plasma were also evaluated under the same conditions. The film lost its thickness at a rate of about 1220 Å/min in the case of PIQ (made by Hitachi Kasei), OFPR-800 (made by Tokyo Ouka Kogyo), and AZ1350J (made by Hoechst). In the case of the above-mentioned polymer, the rate of film thinning was not affected by the content of hydroxyl groups.

The preparation and use of the composition of the invention are described with reference to the following examples, which are not intended to limit the scope of the invention.

Example 1

A photoresist solution containing 27 wt% solids was prepared by dissolving 80 wt% of poly(p-hydroxybenzylsesquioxane) (Polymer XXVII, containing 100% hydroxyl groups) obtained in Synthesis Example 3 and 20 wt% of photosensitive dissolution inhibitor XII in ethylcellosolve acetate.

Then, the resist solution was applied to a silicon wafer by spin coating method. The coating was prebaked at 85°C for 30 minutes to give a 1.0 μm thick resist film.

The resist film thus prepared was exposed to a different amount of light. The exposed resist film was developed for 1 minute with an alkali developing solution prepared by diluting NMD-3 developing solution (2.38% aqueous solution of tetramethylammonium hydroxide, made by Tokyo Ouka Kogyo) to 0.45%. After development, the resist film was washed with water and the thickness of the remaining resist film was measured. The remaining film thickness was plotted against the exposure (mJ/$cm^2$ at 365 nm), and the minimum exposure

at which the ratio of the remaining film is 0 was obtained. (The minimum exposure is defined as sensitivity.) It was about 30 mJ/cm$^2$. This indicates that the positive photoresist has a high sensitivity.

Example 2

A two-layer resist was formed. The lower layer was formed by applying OFPR-800 (made by Tokyo Ouka Kogyo) to a silicon wafer by spin coating to give a 2.0 µm thick coating. The coating was baked at 90°C for 30 minutes and then at 200°C for 30 minutes. The top layer (1.0 µm thick) was formed using the same resist solution and method as in Example 1.

Using the coated silicon wafer, the sensitivity of the resist film was measured in the same manner as in Example 1. It was about 30 mJ/cm$^2$. The coated silicon wafer was also examined for patterning performance. First, the resist film was exposed through a glass mask placed in close contact with the resist film. The top layer was developed in the same manner as in Example 1. A resolution of 0.8 µm was achieved. Using the top layer resist as a mask, the etching of the lower layer was performed with oxygen plasma in a parallel flat plate type $O_2$RIE apparatus ($O_2$ pressure : 3 mtorr, RF 0.64 mW/cm$^2$ (7 MHz), cathode bias voltage – 130V). The pattern of the top layer resist was accurately transferred to the lower layer resist. This result indicates that the resist of the invention can be used as the top layer resist in the two-layer resist method.

Example 3

A two-layer resist was formed. The lower layer was formed by applying PIQ (made by Hitachi Kasei) to a silicon wafer by spin coating to give a 2.0 µm thick coating. The coating was baked at 250°C for 30 minutes and then at 350°C for 30 minutes. The top layer (1.0 µm thick) was formed using the same resist solution and method as in Example 1.

The sensitivity obtained in the same manner as in Example 1 was about 30 mJ/cm$^2$. The patterning of the top layer resist was carried out and the etching of the lower layer resist with oxygen plasma were performed in the same manner as in Example 1. A resolution of 0.8 µm was achieved. This result indicates that the resist of the invention can be used for the fabrication of an organic insulation film.

Examples 4 to 53

Experiments were carried out under varied conditions according to the methods employed in Examples 1 to 3. Tables 1 to 3 show the constituents of the composition, the formulation of the composition, the film thickness, the organic matter on the substrate, the conditions of developing and rinsing, and the sensitivity and resolution in the respective experiments with polymers XXV, XXVI, and XXVII.

The results in the examples demonstrate that the compositions of the invention are superior in sensitivity, resolution, and resistance to oxygen plasma, and they are a useful material for microfabrication.

Table 1 Experiments with Polymer XXV

| Example No. | 4 | 5 | 6 | 7 | 8 |
|---|---|---|---|---|---|
| Top layer resist | | | | | |
| Polymer XXV (wt%) | OH 86% (70) | OH 86% (48) | OH 86% (95) | OH 86% (90) | OH 86% (90) |
| Other polymer (wt%) | - | (32)* | - | - | - |
| Photosensitive dissolution inhibitor (wt%) | II (30) | II (20) | IV ( 5) | XII (10) | XII (10) |
| Film thickness (µm) | 0.2 | 0.2 | 0.2 | 0.2 | 0.8 |
| Organic matter on the substrate | - | - | - | - | - |
| Conditions of developing and rinsing | 3.3% aq. $Me_4NOH$ 20 s pure water 60 s | 3.2% aq. $Me_4NOH$ 30 s pure water 60 s | 3.0% aq. $Me_4NOH$ 30 s pure water 60 s | 2.7% aq. $Me_4NOH$ 100 ml + ethyl cellosolve 24 ml 30 s, pure water 60 s | 2.7% aq. $Me_4NOH$ 100 ml + ethyl cellosolve 24 ml 2 min, pure water 60 s |
| Sensitivity ($mJ/cm^2$ at 365 nm) | 80 | 80 | 100 | 50 | 75 |
| Resolution (µm) | 0.5 | 0.5 | 0.5 | 0.5 | 0.8 |

*Cresol novolak

Table 1 (Continued)

| Example No. | 9 | 10 | 11 | 12 |
|---|---|---|---|---|
| Top layer resist | | | | |
| Polymer XXV (wt%) | OH 86% (90) | OH 86% (90) | OH 86% (90) | OH 86% (90) |
| Other polymer (wt%) | - | - | - | - |
| Photosensitive dissolution inhibitor (wt%) | XII (10) | XII (10) | XII (10) | XII (10) |
| Film thickness (μm) | 0.2 | 0.2 | 0.8 | 0.8 |
| Organic matter on the substrate | PIQ | PIQ | PIQ | PIQ |
| Conditions of developing and rinsing | 3.3% aq. $Me_4NOH$ 20 s pure water 60 s | 2.7% aq. $Me_4NOH$ 100 ml + ethyl cellosolve 24 ml 30 s, pure water 60 s | 3.3% aq. $Me_4NOH$ 2 min pure water 60 s | 2.7% aq. $Me_4NOH$ 100 ml + ethyl cellosolve 24 ml 2 min, pure water 60 s |
| Sensitivity ($mJ/cm^2$ at 365 nm) | 130 | 80 | 110 | 110 |
| Resolution (μm) | 0.5 | 0.5 | 0.8 | 0.8 |

Table 1 (Continued)

| Example No. | 13 | 14 | 15 | 16 |
|---|---|---|---|---|
| **Top layer resist** | | | | |
| Polymer XXV (wt%) | OH 100% (80) | OH 100% (80) | OH 100% (80) | OH 100% (80) |
| Other polymer (wt%) | - | - | - | - |
| Photosensitive dissolution inhibitor (wt%) | XII (20) | XII (20) | XII (20) | XII (20) |
| Film thickness (μm) | 0.2 | 0.8 | 0.2 | 0.8 |
| Organic matter on the substrate | - | - | PIQ | PIQ |
| Conditions of developing and rinsing | 2.7% aq. $Me_4NOH$ 100 ml + ethyl cellosolve 24 ml 30 s, pure water 60 s | 2.7% aq. $Me_4NOH$ 100 ml + ethyl cellosolve 24 ml 2 min, pure water 60 s | 3.3% aq. $Me_4NOH$ 30 s pure water 60 s | 3.3% aq. $Me_4NOH$ 2 min pure water 60 s |
| Sensitivity ($mJ/cm^2$ at 365 nm) | 50 | 80 | 90 | 110 |
| Resolution (μm) | 0.5 | 0.8 | 0.5 | 0.8 |

Table 1 (Continued)

| Example No. | 17 | 18 | 19 | 20 |
|---|---|---|---|---|
| Top layer resist | | | | |
| Polymer XXV (wt%) | OH 70% (80) | OH 70% (80) | OH 70% (80) | OH 70% (80) |
| Other polymer (wt%) | - | - | - | - |
| Photosensitive dissolution inhibitor (wt%) | XII (20) | XII (20) | XII (20) | XII (20) |
| Film thickness (μm) | 0.2 | 0.8 | 0.2 | 0.8 |
| Organic matter on the substrate | - | - | PIQ | PIQ |
| Conditions of developing and rinsing | 2.7% aq. $Me_4NOH$ 100 ml + ethyl cellosolve 24 ml 30 s, pure water 60 s | 2.7% aq. $Me_4NOH$ 100 ml + ethyl cellosolve 24 ml 2 min, pure water 60 s | 3.3% aq. $Me_4NOH$ 30 s pure water 60 s | 3.3% aq. $Me_4NOH$ 2 min pure water 2 min |
| Sensitivity ($mJ/cm^2$ at 365 nm) | 70 | 100 | 120 | 140 |
| Resolution (μm) | 0.5 | 0.8 | 0.5 | 0.8 |

Table 2 Experiments with Polymer XXVI

| Example No. | 21 | 22 | 23 | 24 | 25 |
|---|---|---|---|---|---|
| Top layer resist | | | | | |
| Polymer XXVI (wt%) | OH 90% (75) | OH 90% (91) | OH 90% (87) | OH 90% (91) | OH 90% (83) |
| Other polymer (wt%) | - | - | - | - | - |
| Photosensitive dissolution inhibitor (wt%) | XII (25) | X ( 9) | VI (13) | VII ( 9) | IX (17) |
| Film thickness (μm) | 0.20 | 0.25 | 0.20 | 0.22 | 0.20 |
| Organic matter on the substrate | OFPR-800 | OFPR-800 | OFPR-800 | OFPR-800 | OFPR-800 |
| Conditions of developing and rinsing | 0.5% or 0.6% aq. $Me_4NOH$ 60 s pure water 60 s | 0.5% or 0.6% aq. $Me_4NOH$ 60 s pure water 60 s | 0.5% or 0.6% aq. $Me_4NOH$ 60 s pure water 60 s | 0.5% or 0.6% aq. $Me_4NOH$ 60s pure water 60 s | 0.5% or 0.6% aq. $Me_4NOH$ pure water 60 s |
| Sensitivity ($mJ/cm^2$ at 365 nm) | 120 | 150 | 180 | 180 | 200 |
| Resolution (μm) | 0.5 | 0.5 | 0.5 | 0.5 | 0.5 |

Table 2 (Continued)

| Example No. | 26 | 27 | 28 | 29 | 30 |
|---|---|---|---|---|---|
| Top layer resist | | | | | |
| Polymer XXVI (wt%) | OH 90% (87) | OH 90% (91) | OH 90% (83) | OH 71% (87) | OH 71% (86) |
| Other polymer (wt%) | - | - | - | - | - |
| Photosensitive dissolution inhibitor (wt%) | V (13) | XI ( 9) | VIII (17) | XII (13) | X (14) |
| Film thickness (µm) | 0.20 | 0.26 | 0.20 | 0.45 | 0.40 |
| Organic matter on the substrate | OFPR-800 | OFPR-800 | OFPR-800 | OFPR-800 | OFPR-800 |
| Conditions of developing and rinsing | 0.5% or 0.6% aq. $Me_4NOH$ 60 s pure water 60 s | 0.5% or 0.6% aq. $Me_4NOH$ 60 s pure water 60 s | 0.5% or 0.6% aq. $Me_4NOH$ 60 s pure water 60 s | 0.7% aq. $Me_4NOH$ 60 s pure water 60 s | 0.7% aq. $Me_4NOH$ 60 s pure water 60 s |
| Sensitivity ($mJ/cm^2$ at 365 nm) | 150 | 150 | 150 | 180 | 200 |
| Resolution (µm) | 0.5 | 0.5 | 0.5 | 0.5 | 0.5 |

Table 2 (Continued)

| Example No. | 31 | 32 | 33 | 34 | 35 |
|---|---|---|---|---|---|
| Top layer resist | | | | | |
| Polymer XXVI (wt%) | OH 71% (83) | OH 71% (83) | OH 71% (83) | OH 71% (87) | OH 71% (87) |
| Other polymer (wt%) | - | - | - | - | - |
| Photosensitive dissolution inhibitor (wt%) | VI (17) | VII (17) | IX (17) | V (13) | XI (13) |
| Film thickness (μm) | 0.35 | 0.25 | 0.35 | 0.30 | 0.30 |
| Organic matter on the substrate | OFPR-800 | OFPR-800 | OFPR-800 | OFPR-800 | OFPR-800 |
| Conditions of developing and rinsing | 0.7% aq. $Me_4NOH$ 60 s pure water 60 s | 0.7% aq. $Me_4NOH$ 60 s pure water 60 s | 0.7% aq. $Me_4NOH$ 60 s pure water 60 s | 0.7% aq. $Me_4NOH$ 60 s pure water 60 s | 0.7% aq. $Me_4NOH$ 60 s pure water 60 s |
| Sensitivity (mJ/cm² at 365 nm) | 150 | 180 | 150 | 160 | 180 |
| Resolution (μm) | 0.5 | 0.5 | 0.5 | 0.5 | 0.5 |

Table 3 Experiments with Polymer XXVII

| Example No. | 36 | 37 | 38 | 39 |
|---|---|---|---|---|
| Top layer resist | | | | |
| Polymer XXVII (wt%) | OH 70% (90) | OH 70% (80) | OH 85% (90) | OH 85% (80) |
| Other polymer (wt%) | - | - | - | - |
| Photosensitive dissolution inhibitor (wt%) | XII (10) | XII (20) | XII (10) | XII (20) |
| Film thickness (µm) | 1.0 | 1.0 | 1.0 | 1.0 |
| Organic matter on the substrate | - | - | - | - |
| Conditions of developing and rinsing | 0.63% aq. $Me_4NOH$ 60 s pure water 60 s | 0.63% aq. $Me_4NOH$ 60 s pure water 60 s | 0.55% aq. $Me_4NOH$ 60 s pure water 60 s | 0.55% aq. $Me_4NOH$ 60 s pure water 60 s |
| Sensitivity (mJ/cm² at 365 nm) | 50 | 60 | 50 | 60 |
| Resolution (µm) | 0.8 | 0,8 | 0.8 | 0.8 |

Table 3 (Continued)

| Example No. | 40 | 41 | 42 | 43 | 44 |
|---|---|---|---|---|---|
| Top layer resist | | | | | |
| Polymer XXVII (wt%) | OH 100% (90) | OH 100% (80) | OH 100% (80) | OH 100% (80) | OH 100% (80) |
| Other polymer (wt%) | - | - | - | - | - |
| Photosensitive dissolution inhibitor (wt%) | XII (10) | XII (20) | II, (10) XII (10) | X, XI, XII (20) 88% * | X, XI, XII (20) 67% * |
| Film thickness (μm) | 1.0 | 1.0 | 1.0 | 1.0 | 1.0 |
| Organic matter on the substrate | - | - | - | - | - |
| Conditions of developing and rinsing | 0.45% aq. $Me_4NOH$ 60 s pure water 60 s | 0.45% aq. $Me_4NOH$ 60 s pure water 60 s | 0.45% aq. $Me_4NOH$ 60 s pure water 60 s | 0.45% aq. $Me_4NOH$ 60 s pure water 60 s | 0.45% aq. $Me_4NOH$ 60 s pure water 60 s |
| Sensitivity (mJ/cm² at 365 nm) | 40 | 50 | 60 | 50 | 70 |
| Resolution (μm) | 0.8 | 0.8 | 0.8 | 0.8 | 0.8 |

* Ratio of esterification

Table 3 (Continued)

| Example No. | 45 | 46 | 47 | 48 |
|---|---|---|---|---|
| Top layer resist | | | | |
| Polymer XXVII (wt%) | OH 100% (80) | OH 100% (80) | OH 100% (80) | OH 100% (75) |
| Other polymer (wt%) | - | - | - | - |
| Photosensitive dissolution inhibitor (wt%) | X, XI, XII (10) 88%* | X, XI, XII (20) 67%* | X, XI, XII (10) 50%* | X, XI, XII (25) 88%* |
| Film thickness (μm) | 1.0 | 1.0 | 1.0 | 1.0 |
| Organic matter on the substrate | - | - | - | - |
| Conditions of developing and rinsing | 0.45% NMD-3 60 s pure water 60 s | 0.45% NMD-3 60 s pure water 60 s | 0.45% NMD-3 60 s pure water 60 s | 0.45% NMD-3 60 s pure water 60 s |
| Sensitivity ($mJ/cm^2$ at 365 nm) | 30 | 50 | 80 | 35 |
| Resolution (μm) | 0.8 | 0.8 | 0.8 | 0.8 |

* Ratio of esterification

Table 3 (Continued)

| Example No. | 49 | 50 | 51 | 52 | 53 |
|---|---|---|---|---|---|
| Top layer resist | | | | | |
| Polymer XXVII (wt%) | OH 100% (85) | OH 100% (80) | OH 100% (80) | OH 100% (80) | OH 100% (80) |
| Other polymer (wt%) | - | - | - | - | - |
| Photosensitive dissolution inhibitor (wt%) | X, XI, XII (15) 88% * | X, XI, XII (20) 88% * | X, XI, XII (20) 67% * | X, XI, XII (20) 88% * | X, XI, XII (20) 67% * |
| Film thickness (μm) | 1.0 | 1.0 | 1.0 | 1.0 | 1.0 |
| Organic matter on the substrate | - | OFPR-800 | OFPR-800 | PIQ | PIQ |
| Conditions of developing and rinsing | 0.45% NMD-3 60 s pure water 60 s | 0.45% NMD-3 60 s pure water 60 s | 0.45% NMD-3 60 s pure water 60 s | 0.45% NMD-3 60 s pure water 60 s | 0.45% NMD-3 60 s pure water 60 s |
| Sensitivity ($mJ/cm^2$ at 365 nm) | 25 | 30 | 50 | 30 | 50 |
| Resolution (μm) | 0.8 | 0.8 | 0.8 | 0.8 | 0.8 |

* Ratio of esterification

## Claims

1. A photosensitive resin composition comprising an alkali-soluble organosilicon polymer in which all or a part of the silicon atoms contained therein are present in the main chain and all or a part of the side chains are organic groups having phenolic hydroxyl groups, and a o-quinonediazide as photosensitive dissolution inhibitor.

2. The composition of claim 1 wherein said organosilicon polymer is a silmethylene polymer.

3. The composition of claim 2, wherein said silmethylene polymer contains units of the formula (1) which account for more than 40% of the polymer skeleton

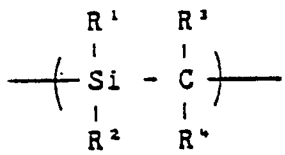

(1)

wherein the four side chains $R^1$, $R^2$, $R^3$ and $R^4$ are monovalent organic groups at least one of which carries a phenolic hydroxyl group.

4. The composition of claim 3, wherein $R^1$ and $R^2$ are methyl groups, $R^3$ is hydrogen, and $R^4$ is a p-hydroxyphenyl group.

5. The composition of claim 1, wherein said organosilicon polymer is a siloxane polymer.

6. The composition of claim 5, wherein said siloxane polymer contains units of the formula (2) which account for more than 40% of the polymer skeleton

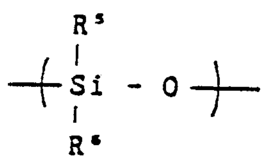

(2)

wherein $R^5$ and $R^6$ are monovalent organic groups at least one of which carries a phenolic hydroxyl group.

7. The composition of claim 6, wherein $R^5$ is a methyl group and $R^6$ is a p-hydroxybenzyl group.

8. The composition of claim 1, wherein said organosilicon polymer is a polyorganosilsesquioxane polymer.

9. The compositoin of claim 8, wherein said polyorganosilsesquioxane contains units of the formula (3) which account for more than 40% of the polymer skeleton

$$[R^7\text{-}SiO_{3/2}] \quad (3)$$

wherein $R^7$ is an organic group having a phenolic hydroxyl group.

10. The composition of claim 9, wherein $R^7$ is a p-hydroxybenzyl group.

11. The composition of claim 1, wherein said o-quinonediazide is a 1,2-napthtohquinonediazide of the formula (4)

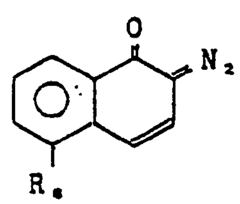

(4)

wherein $R_8$ is a monovalent organic group.

12. The composition of claim 1, wherein said organosilicon polymer is present in an amount from 70 to 95% by weight and said o-quinonediazide is present in an amount from 5 to 30% by weight.

13. The composition of claim 1, wherein said organosilicon polymer contains up to 40% by weight of a film former.

14. The composition of claim 13, wherein said film former is a novolac resin.

15. The use of the photosensitive resin composition of any of claims 1 to 14 for forming fine patterns on a substrate, in particular on silicon wafers.

## Ansprüche

1. Photosensitive Harz-Zusammensetzung umfassend ein in Alkali lösliches siliciumorganisches Polymer, in dem alle oder ein Teil der darin enthaltenen Siliciumatome in der Hauptkette vorhanden sind und alle oder ein Teil der Seitenketten organische Gruppen mit phenolischen Hydroxylgruppen sind, und ein o-Chinondiazid als photosensitiven Auflösungs-Inhibitor.

2. Zusammensetzung nach Anspruch 1, wobei das siliciumorganische Polymer ein Silmethylenpolymer ist.

3. Zusammensetzung nach Anspruch 2, wobei das Silmethylenpolymer Einheiten der Formel (1) enthält, welche mehr als 40% des Polymergerüsts ausmachen

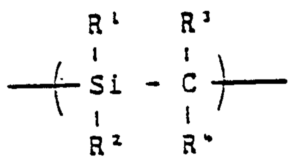

(1)

wobei die vier Seitenketten $R^1$, $R^2$, $R^3$ and $R^4$ einwertige organische Gruppen sind, von denen mindestens eine eine phenolische Hydroxylgruppe trägt.

4. Zusammensetzung nach Anspruch 3, wobei $R^1$ and $R^2$ Methylgruppen sind, $R^3$ Wasserstoff ist und $R^4$ eine p-Hydroxyphenyl-Gruppe ist.

5. Zusammensetzung nach Anspruch 1, wobei das siliciumorganische Polymer ein Siloxan-Polymer ist.

6. Zusammensetzung nach Anspruch 5, wobei das Siloxan-Polymer Einheiten der Formel (2) enthält, welche mehr als 40% des Polymergerüsts ausmachen

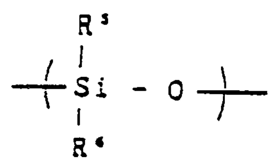

(2)

wobei $R^5$ und $R^6$ einwertige organische Gruppen sind, von denen mindestens eine eine phenolische Hydroxylgruppe trägt.

7. Zusammensetzung nach Anspruch 6, wobei $R^5$ eine Methyl-Gruppe ist und $R^6$ eine p-Hydroxybenzyl-Gruppe ist.

8. Zusammensetzung nach Anspruch 1, wobei das siliciumorganische Polymer ein Polyorganosilsesquioxan-Polymer ist.

9. Zusammensetzung nach Anspruch 8, wobei das Polyorganosilsesquioxan Einheiten der Formel (3) enthält, welche mehr als 40% des Polymergerüsts ausmachen

$$[R^7\text{-}SiO_{3/2}] \quad (3)$$

wobei $R_7$ eine organische Gruppe mit einer phenolischen Hydroxylgruppe ist.

10. Zusammensetzung nach Anspruch 9, wobei $R^7$ eine p-Hydroxybenzyl-Gruppe ist.

11. Zusammensetzung nach Anspruch 1, wobei das o-Chinondiazid ein 1,2-Naphthochinondiazid der Formel (4) ist

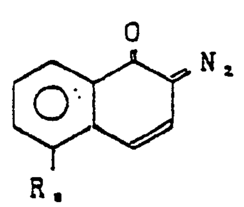

(4)

wobei $R_8$ eine einwertige organische Gruppe ist.

12. Zusammensetzung nach Anspruch 1, wobei des siliciumorganische Polymer in einer Menge von 70-95 Gewichts-% und das o-Chinondiazid in einer Menge von 5-30 Gewichts-% vorhanden ist.

13. Zusammensetzung nach Anspruch 1, wobei das siliciumorganische Polymer bis zu 40 Gewichts-%

eines Filmbildners enthalt.

14. Zusammensetzung nach Anspruch 13, wobei der Filmbildner ein Novolakharz ist.

15. Verwendung der photosensitiven Harz-Zusammensetzung nach einem der Ansprüche 1-14 zur Erzeugung feiner Muster auf einem Substrat, insbesondere auf Silicium-Plättchen.

## Revendications

1. Composition de résine photosensible, comprenant un polymère organosilicique soluble dans les alcalis, dans lequel tout ou une partie des atomes de silicium sont présents dans la chaîne principale, et tout ou une partie des chaînes latérales sont des groupes organiques ayant des groupes hydroxy phénoliques, et un o-quinonediazide comme inhibiteur de dissolution photosensible.

2. Composition selon la revendication 1, dans laquelle ledit polymère organosilicique est un polymère silméthylène.

3. Composition selon la revendication 2, dans laquelle ledit polymère silméthylène contient des unités de formule (1) qui constituent plus de 40% du squelette du polymère

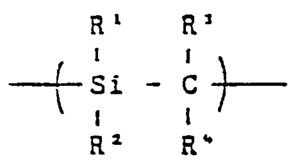 (1)

où les quatre chaînes latérales $R^1$, $R^2$, $R^3$ et $R^4$ sont des groupes organiques monovalents dont au moins l'un porte un groupe hydroxy phénolique.

4. Composition selon la revendication 3, dans laquelle $R^1$ et $R^2$ sont des groupes méthyle, $R^3$ est l'hydrogène et $R^4$ est un groupe p-hydroxyphényle.

5. Composition selon la revendication 1, dans laquelle ledit polymère organosilicique est un polymère siloxane.

6. Composition selon la revendication 5, dans laquelle ledit polymère siloxane contient des unités de formule (2) qui constituent plus de 40% du squelette du polymère

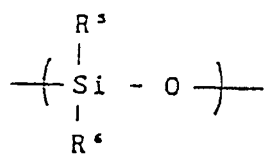 (2)

où $R^5$ et $R^6$ sont des groupes organiques monovalents dont au moins l'un porte un groupe hydroxy phénolique.

7. Composition selon la revendication 6, dans laquelle $R^5$ est un groupe méthyle et $R^6$ est un groupe p-hydroxybenzyle.

8. Composition selon la revendication 1, dans laquelle ledit polymère organosilicique est un polymère polyorganosilsesquioxane.

9. Composition selon la revendication 8, dans laquelle ledit polyorganosilsesquioxane contient des unités de formule (3) qui constituent plus de 40% du squelette du polymère

$$[R^7\text{-}SiO_{3/2}] \quad (3)$$

où $R^7$ est un groupe organique ayant un groupe hydroxy phénolique.

10. Composition selon la revendication 9, dans laquelle $R^7$ est un groupe p-hydroxybenzyle.

11. Composition selon la revendication 1, dans laquelle ledit o-quinonediazide est le 1,2-naphtoquinonediazide de formule (4)

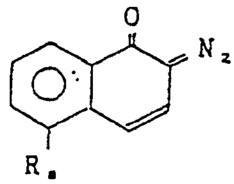

(4)

où $R_8$ est un groupe organique monovalent.

12. Composition selon la revendication 1, dans laquelle ledit polymère organosilicique est présent en une proportion de 70 à 95% en poids et ledit o-quinonediazide est présent en une proportion de 5 à 30% en poids.

13. Composition selon la revendication 1, dans laquelle ledit polymère organosilicique contient jusqu'à 40% en poids d'un formateur de film.

14. Composition selon la revendication 13, dans laquelle ledit formateur de film est une résine novolaque.

15. Utilisation de la composition de résine photosensible selon l'une quelconque des revendications 1 à 14, pour former des motifs fins sur un substrat, en particulier sur des tranches de silicium.